# EUROPEAN PATENT SPECIFICATION

(11) **EP 2 618 092 B1**
(45) Date of publication and mention of the grant of the patent: **06.03.2019**
(21) Application number: 12196469.6
(22) Date of filing: 11.12.2012
(51) Int. Cl.: F28F 3/02, F28F 3/06, F28D 15/02

(54) **Heat dissipating device**
Wärmeableitungsvorrichtung
Dispositif de dissipation de chaleur

(30) Priority: 20.01.2012 TW 101201652 U
(43) Date of publication of application: 24.07.2013
(73) Proprietor: Cooler Master Development Corporation, New Taipei City, Taiwan R.O.C. (TW)
(72) Inventor: Lin, Chia-Yu, 235 New Taipei City (TW)
(74) Representative: Becker Kurig Straus

(56) References cited:
- US-A- 5 653 019
- US-A1- 2004 141 291
- US-A1- 2006 090 873
- US-A1- 2007 074 850

## Description

### Field of the Invention

The present invention relates to a method of producing a heat dissipating device according to the pre-characterizing clauses of claim 1.

### Background of the Invention

A heat dissipating device is a significant component for electronic products. When an electronic product is operating, the current in circuits will generate unnecessary heat due to impedance. If the heat is accumulated in the electronic components of the electronic product without dissipating immediately, the electronic components may be damaged due to the accumulated heat. Therefore, the performance of a heat dissipating device is a significant issue for the electronic product.

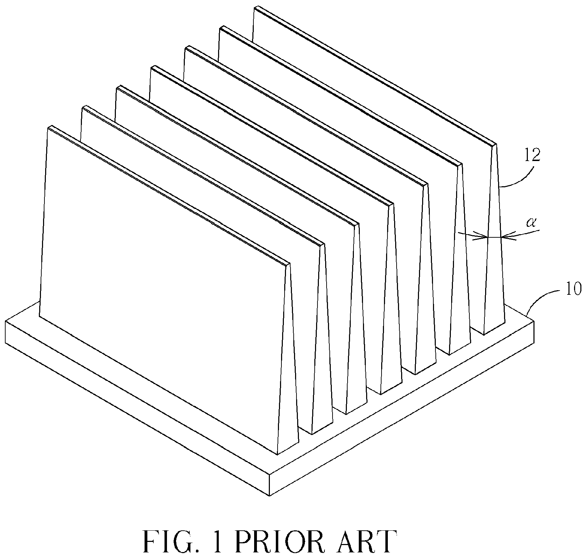

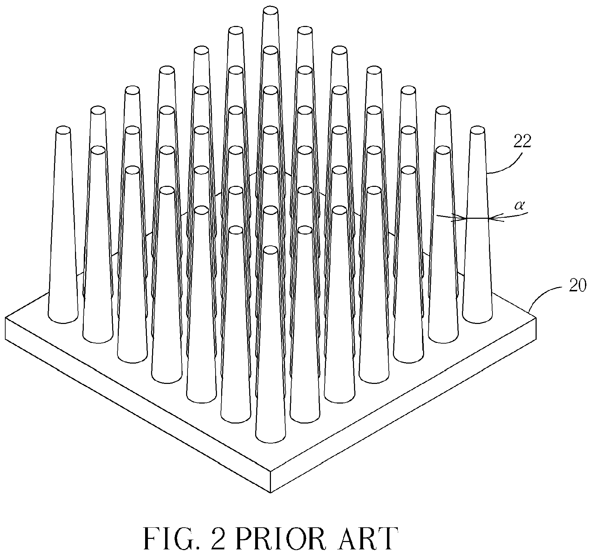

Referring to FIGs. 1 and 2, FIG. 1 is a schematic diagram illustrating a flat-type heat dissipating fin 12 of the prior art, and FIG. 2 is a schematic diagram illustrating a cylinder-type heat dissipating fin 22 of the prior art. In general, a heat dissipating device is usually equipped with a flat-type heat dissipating fin 12 shown in FIG. 1 or a cylinder-type heat dissipating fin 22 shown in FIG. 2. As shown in FIGs. 1 and 2, the flat-type heat dissipating fin 12 and the cylinder-type heat dissipating fin 22 are formed with the bases 10, 20 integrally by a die casting process. Due to the requirement of mold stripping during the die casting process, the flat-type heat dissipating fin 12 or the cylinder-type heat dissipating fin 22 has a draft angle α between 2 degrees and 3 degrees so that the whole weight is heavy and the height of the fin is limited. Furthermore, the number of heat dissipating fins is reduced in the heat dissipating device due to the draft angle α so that the heat dissipating area is lessened and the heat dissipating efficiency is reduced.

Furthermore, since the conventional bases 10, 20 are formed as flat plates, once a heat dissipating device is attached on an outdoor electronic device with the bases 10, 20, the electronic device will be exposed out of the periphery of the bases 10, 20. Consequently, the electronic device will be battered and damaged by wind and rain.

Moreover, the related art US Patent Application Publication No. US 2006/090873 A1 discloses a method for manufacturing heat sink devices, more specifically to manufacture a heat sink device of which the heat-sinking fins are integrally formed with the base.

### Summary of the Invention

This in mind, the present invention aims at providing a heat dissipating device with a box capable of accommodating electronic device(s) such that the heat dissipating device can be used outside and providing the heat dissipating device with a heat dissipating fin capable of preventing overflow during the manufacturing process, thereby resolving the aforesaid problems.

This is achieved by a method of producing a heat dissipating device according to claim 1. The dependent claims pertain to corresponding further developments and improvements.

As will be seen more clearly from the detailed description following below, the claimed method of producing a heat dissipating device includes steps of forming a plurality of heat dissipating fins by a forming process, wherein each of the heat dissipating fins includes a heat dissipating portion, a fixing portion and an overflow-proof structure connected between the heat dissipating portion and the fixing portion; putting the fixing portion of each of the heat dissipating fins into a mold; pouring a melt metal material into the mold; and processing the melt metal material by a die casting process so as to form a base, wherein the base includes a substrate and a box, the substrate and the box are formed integrally, the box has an accommodating space therein, and the substrate covers the fixing portion of each of the heat dissipating fins; wherein a width of the overflow-proof structure is larger than a width of the heat dissipating portion and larger than a width of the fixing portion, such that the overflow-proof structure of each of the heat dissipating fins is capable of preventing the melt metal material from overflowing during the die casting process.

### Brief Description of the Drawings

In the following, the invention is further illustrated by way of example, taking reference to the accompanying drawings thereof:
FIG. 1 is a schematic diagram illustrating a flat-type heat dissipating fin of the prior art,
FIG. 2 is a schematic diagram illustrating a cylinder-type heat dissipating fin of the prior art,
FIG. 3 is a schematic diagram illustrating a heat dissipating device according to an embodiment of the invention,
FIG. 4 is a cross-sectional view illustrating the heat dissipating device along line A-A shown in FIG. 3,
FIG. 5 is a schematic diagram illustrating the heat dissipating fin shown in FIG. 3,
FIG. 6 is a flowchart illustrating a method of manufacturing the heat dissipating device shown in FIG. 3,
FIG. 7 is a cross-sectional view illustrating a heat dissipating device according to an embodiment of the invention,
FIG. 8 is a cross-sectional view illustrating a heat dissipating device according to an embodiment of the invention,
FIG. 9 is a cross-sectional view illustrating a heat dissipating fin according to an embodiment of the invention,
FIG. 10 is a cross-sectional view illustrating a heat dissipating fin according to an embodiment of the invention,
FIG. 11 is a cross-sectional view illustrating a heat dissipating fin according to an embodiment of the invention,
FIG. 12 is a schematic diagram illustrating a heat dissipating device according to an embodiment of the invention,
FIG. 13 is a cross-sectional view illustrating the heat dissipating device along line B-B shown in FIG. 12,
FIG. 14 is a schematic diagram illustrating the heat dissipating fin shown in FIG. 12,
FIG. 15 is a flowchart illustrating a method of manufacturing the heat dissipating device shown in FIG. 12, and
FIG. 16 is a cross-sectional view illustrating a heat dissipating fin according to an embodiment of the invention.

### Detailed Description

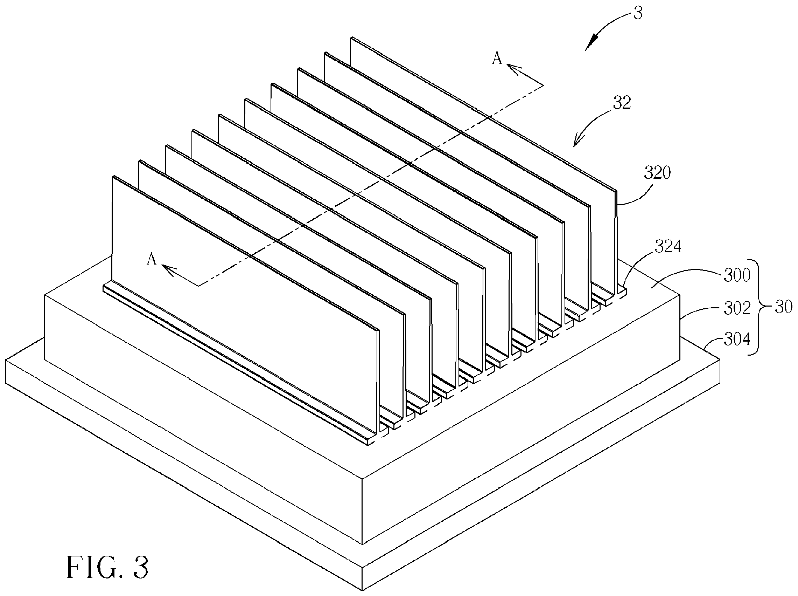

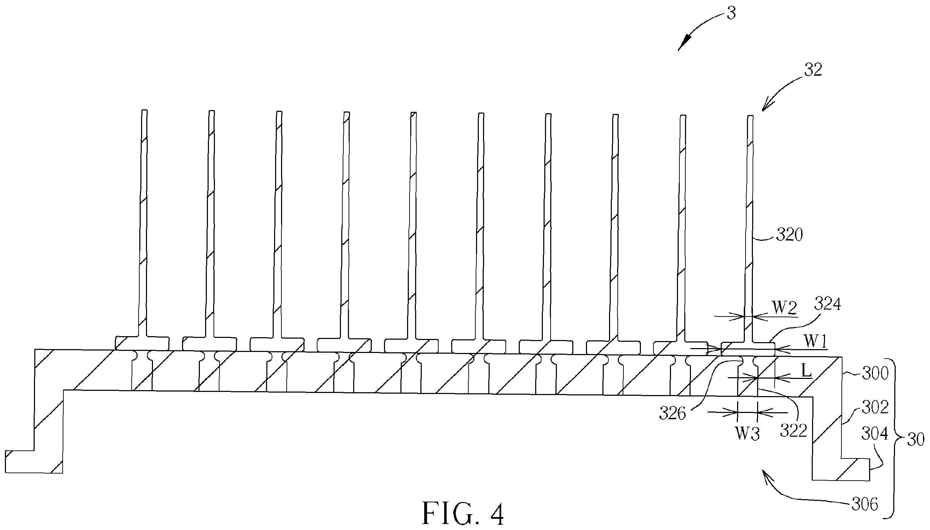

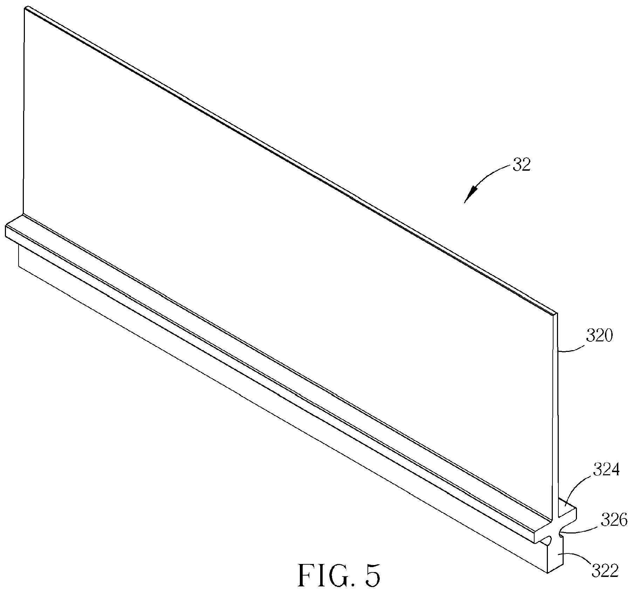

Referring to FIGs. 3 to 5, FIG. 3 is a schematic diagram illustrating a heat dissipating device 3 according to an embodiment of the invention, FIG. 4 is a cross-sectional view illustrating the heat dissipating device 3 along line A-A shown in FIG. 3, and FIG. 5 is a schematic diagram illustrating the heat dissipating fin 32 shown in FIG. 3. As shown in FIGs. 3 and 4, the heat dissipating device 3 includes a base 30 and a plurality of heat dissipating fins 32. The base 30 includes a substrate 300, a box 302 and a flange 304, wherein the substrate 300 and the box 302 are formed integrally, the box 302 has an accommodating space 306 therein, and the flange 304 protrudes from a periphery of the box 302. In practical applications, the flange 304 may be fixed on a plane by screw, rivet, soldering or other fixing manners so as to fix the heat dissipating device 3 on the plane. When the heat dissipating device 3 of the invention is installed outside (e.g. outdoor base station), electronic device(s) can be accommodated in the accommodating space 306 within the box 302 of the base 30 so as to protect the electronic device(s) from being battered and damaged by wind and rain.

As shown in FIGs. 4 and 5, each of the heat dissipating fins 32 includes a heat dissipating portion 320, a fixing portion 322 and an overflow-proof structure 324. The fixing portion 322 is fixed in the base 30. The overflow-proof structure 324 is connected between the heat dissipating portion 320 and the fixing portion 322. A width W1 of the overflow-proof structure 324 is larger than a width W2 of the heat dissipating portion 320 and larger than a width W3 of the fixing portion 322. In this embodiment, a length L of the overflow-proof structure 324 protruded from the fixing portion 322 can be between 1 mm and 10 mm, wherein a thickness of the overflow-proof structure 324 is uniform. In another embodiment, a thickness of the overflow-proof structure 324 may vary gradiently.

Furthermore, each of the heat dissipating fins 32 may further include a recess structure 326 formed on the fixing portion 322. In this embodiment, the recess structure 326 is arc-shaped. In another embodiment, the recess structure 326 may be polygon-shaped.

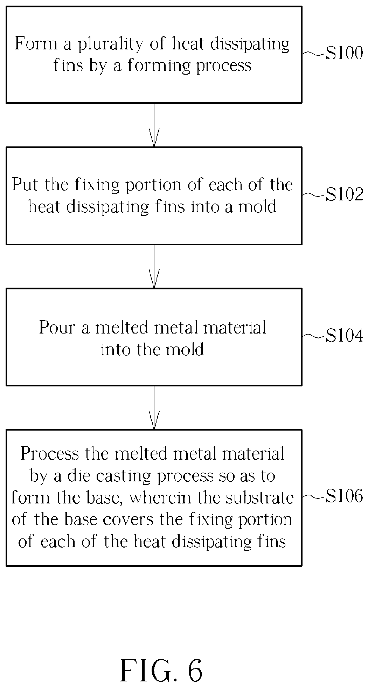

Referring to FIG. 6, FIG. 6 is a flowchart illustrating a method of manufacturing the heat dissipating device 3 shown in FIG. 3, according to the present invention. First of all, step S100 is performed to form a plurality of heat dissipating fins 32 by a forming process. In this embodiment, the aforesaid forming process may be an aluminum extrusion process so as to form each of the heat dissipating fins 32 as a flat-type heat dissipating fin. Afterward, step S102 is performed to put the fixing portion 322 of each of the heat dissipating fins 32 into a mold (not shown). Step S104 is then performed to pour a melt metal material (e.g. aluminum, etc.) into the mold. Finally, step S106 is performed to process the melt metal material by a die casting process so as to form the base 30, wherein the substrate 300 of the base 30 covers the fixing portion 322 of each of the heat dissipating fins 32, as shown in FIG. 4. In this embodiment, the overflow-proof structure 324 of each of the heat dissipating fins 32 is capable of preventing the melt metal material from overflowing during the die casting process so as to prevent deckle edge from being generated. When the length L of the overflow-proof structure 324 protruded from the fixing portion 322 is between 1 mm and 10 mm, the overflow-proof structure 324 can prevent the melt metal material from overflowing during the die casting process effectively so as to prevent deckle edge from being generated. Furthermore, the recess structure 326 of each of the heat dissipating fins 32 can hold the metal material effectively so as to enhance the combination strength between the base 30 and the heat dissipating fins 32.

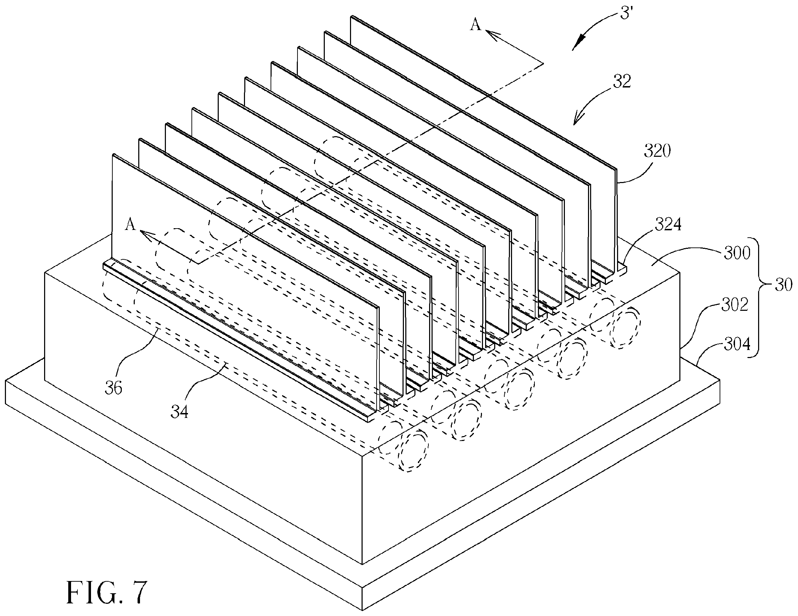

Referring to FIG. 7 along with FIG. 3, FIG. 7 is a cross-sectional view illustrating a heat dissipating device 3' according to an embodiment of the invention. The difference between the heat dissipating device 3' and the aforesaid heat dissipating device 3 is that the heat dissipating device 3' further includes a plurality of heat pipes 34 disposed in the substrate 300 of the base 30 so as to enhance heat dissipating efficiency. It should be noted that if the base 30 is formed by aluminum die casting process, each of the heat pipes 34 may be disposed in an aluminum sleeve 36 and then the heat pipe 34 and the aluminum sleeve 36 are put into a mold with the heat dissipating fins 32 for the die casting process. Accordingly, the combination strength between the heat pipes 34 and the base 30 can be improved. Furthermore, the same elements in FIG. 7 and FIG. 3 are represented by the same numerals, so the repeated explanation will not be depicted herein again.

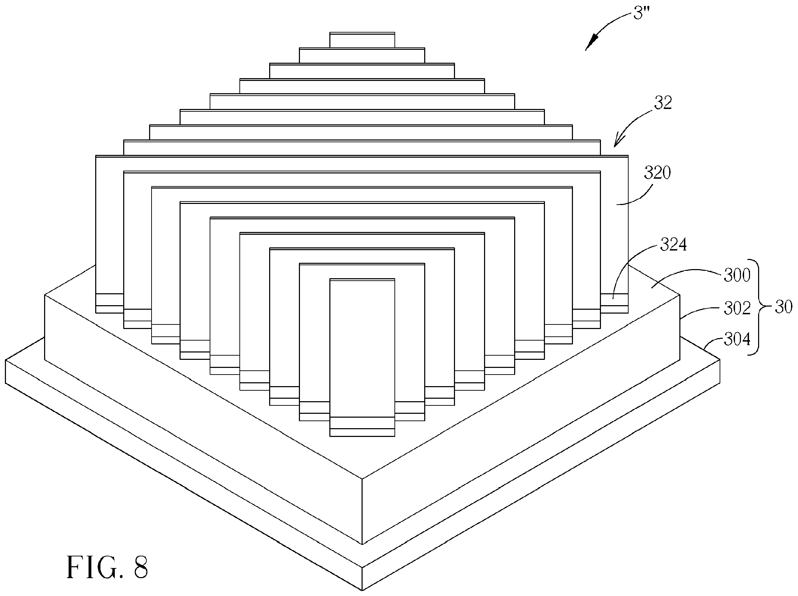

Referring to FIG. 8 along with FIG. 3, FIG. 8 is a cross-sectional view illustrating a heat dissipating device 3" according to an embodiment of the invention. The differences between the heat dissipating device 3" and the aforesaid heat dissipating device 3 are the angles of the heat dissipating fins 32 with respect to the base 30. In other words, the angles of the heat dissipating fins 32 with respect to the base 30 can be determined based on practical applications. For further description, the heat dissipating fins 32 of the heat dissipating device 3 are substantially perpendicular to one edge of the substrate 300 and parallel to another edge of the substrate 300. Moreover, the heat dissipating fins 32 of the heat dissipating device 3" are substantially oblique to any edge of the substrate 300.

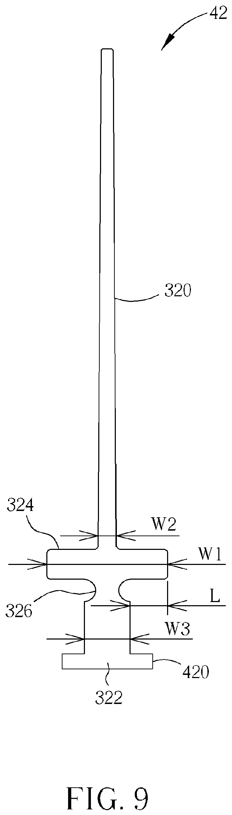

Referring to FIG. 9 along with FIG. 4, FIG. 9 is a cross-sectional view illustrating a heat dissipating fin 42 according to an embodiment of the invention. The difference between the heat dissipating fin 42 and the aforesaid heat dissipating fin 32 is that the heat dissipating fin 42 further includes a protruding structure 420. As shown in FIG. 9, the protruding structure 420 protrudes from one end of the fixing portion 322. When the heat dissipating fin 32 shown in FIG. 4 is replaced by the heat dissipating fin 42 shown in FIG. 9, the protruding structure 420 of the heat dissipating fin 42 can cooperate with the overflow-proof structure 324 to hold the metal material so as to enhance the combination strength between the base 30 and the heat dissipating fin 42. It should be noted that the same elements in FIG. 9 and FIG. 4 are represented by the same numerals, so the repeated explanation will not be depicted herein again. Moreover, the heat dissipating fin 42 can also be formed by the forming process of the aforesaid step S100.

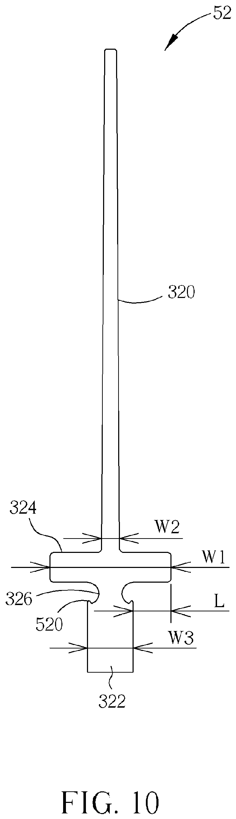

Referring to FIG. 10 along with FIG. 4, FIG. 10 is a cross-sectional view illustrating a heat dissipating fin 52 according to an embodiment of the invention. The difference between the heat dissipating fin 52 and the aforesaid heat dissipating fin 32 is that the heat dissipating fin 52 further includes a hook structure 520. As shown in FIG. 10, the hook structure 520 is formed in the recess structure 326. When the heat dissipating fin 32 shown in FIG. 4 is replaced by the heat dissipating fin 52 shown in FIG. 10, the hook structure 520 of the heat dissipating fin 52 can hook the metal material so as to enhance the combination strength between the base 30 and the heat dissipating fin 52. It should be noted that the same elements in FIG. 10 and FIG. 4 are represented by the same numerals, so the repeated explanation will not be depicted herein again. Moreover, the heat dissipating fin 52 can also be formed by the forming process of the aforesaid step S100.

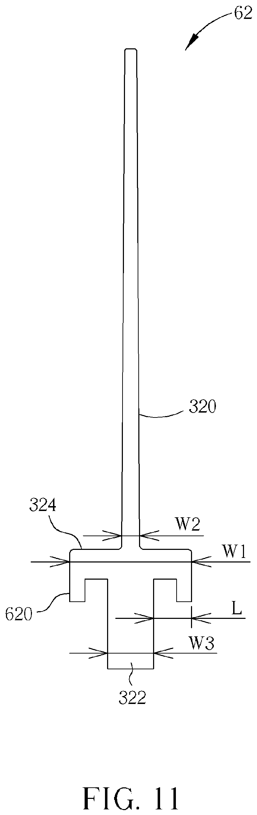

Referring to FIG. 11 along with FIG. 4, FIG. 11 is a cross-sectional view illustrating a heat dissipating fin 62 according to an embodiment of the invention. The difference between the heat dissipating fin 62 and the aforesaid heat dissipating fin 32 is that the heat dissipating fin 62 further includes an extending structure 620 and does not include the aforesaid recess structure 326. As shown in FIG. 11, the extending structure 620 is extended from the overflow-proof structure 324 toward the fixing portion 322, and the overflow-proof structure 324 and the extending structure 620 are formed as a U-shape. When the heat dissipating fin 32 shown in FIG. 4 is replaced by the heat dissipating fin 62 shown in FIG. 11, the extending structure 620 of the heat dissipating fin 62 can cooperate with the overflow-proof structure 324 to hold the metal material so as to enhance the combination strength between the base 30 and the heat dissipating fin 62. It should be noted that the same elements in FIG. 11 and FIG. 4 are represented by the same numerals, so the repeated explanation will not be depicted herein again. Moreover, the heat dissipating fin 62 can be also formed by the forming process of the aforesaid step S100.

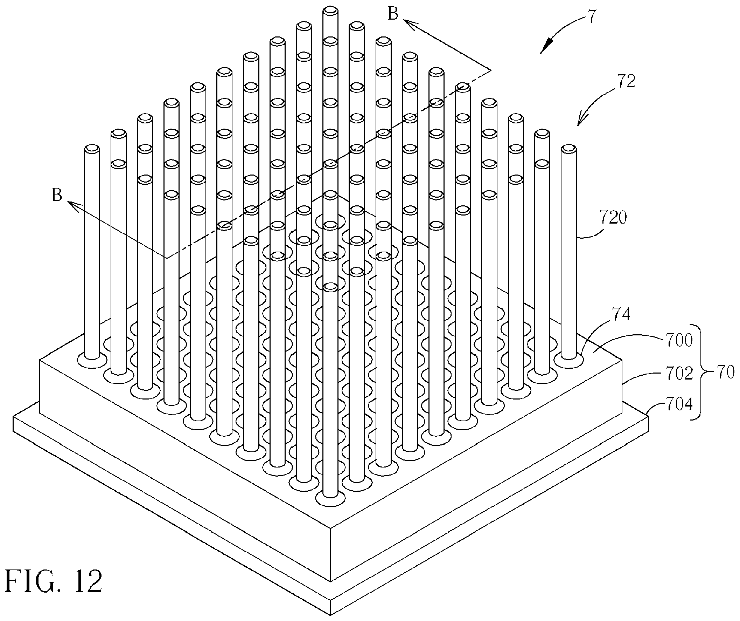

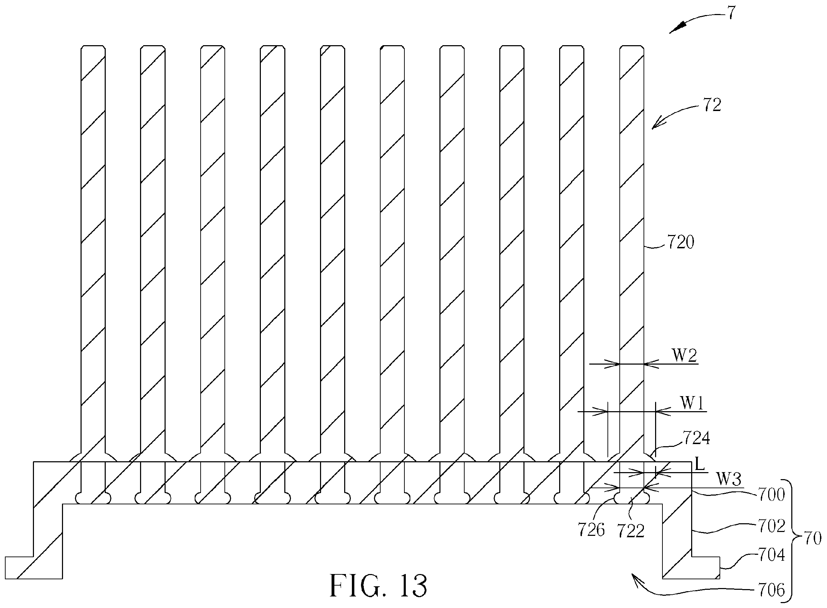

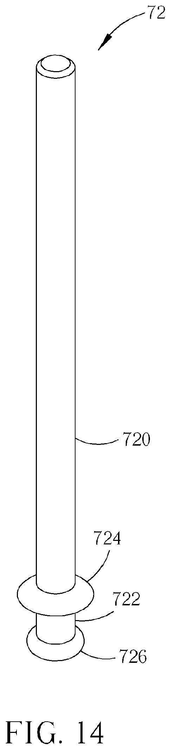

Referring to FIGs. 12 to 14, FIG. 12 is a schematic diagram illustrating a heat dissipating device 7 according to an embodiment of the invention, FIG. 13 is a cross-sectional view illustrating the heat dissipating device 7 along line B-B shown in FIG. 12, and FIG. 14 is a schematic diagram illustrating the heat dissipating fin 72 shown in FIG. 12. As shown in FIGs. 12 and 13, the heat dissipating device 7 includes a base 70 and a plurality of heat dissipating fins 72. The base 70 includes a substrate 700, a box 702 and a flange 704, wherein the substrate 700 and the box 702 are formed integrally, the box 702 has an accommodating space 706 therein, and the flange 704 protrudes from a periphery of the box 702. In practical applications, the flange 704 may be fixed on a plane by screw, rivet, soldering or other fixing manners so as to fix the heat dissipating device 7 on the plane. When the heat dissipating device 7 of the invention is installed outside (e.g. outdoor base station), electronic device(s) can be accommodated in the accommodating space 706 within the box 702 of the base 70 so as to protect the electronic device(s) from being battered and damaged by wind and rain.

As shown in FIGs. 13 and 14, each of the heat dissipating fins 72 includes a heat dissipating portion 720, a fixing portion 722, an overflow-proof structure 724 and a protruding structure 726. The fixing portion 722 and the protruding structure 726 are fixed in the base 70. The overflow-proof structure 724 is connected between the heat dissipating portion 720 and the fixing portion 722. A width W1 of the overflow-proof structure 724 is larger than a width W2 of the heat dissipating portion 720 and larger than a width W3 of the fixing portion 722. In this embodiment, a length L of the overflow-proof structure 724 protruded from the fixing portion 722 can be between 1 mm and 10 mm. The protruding structure 726 protrudes from one end of the fixing portion 722. In this embodiment, a thickness of the overflow-proof structure 724 varies gradiently. In another embodiment, a thickness of the overflow-proof structure 724 may be uniform.

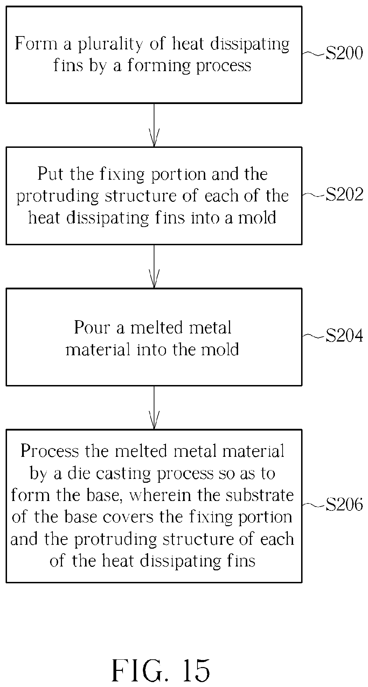

Referring to FIG. 15, FIG. 15 is a flowchart illustrating a method of manufacturing the heat dissipating device 7 shown in FIG. 12, according to the present invention. First of all, step S200 is performed to form a plurality of heat dissipating fins 72 by a forming process. In this embodiment, the aforesaid forming process may be a rivet forming process so as to form each of the heat dissipating fins 72 as a cylinder-type heat dissipating fin. Afterward, step S202 is performed to put the fixing portion 722 and the protruding structure 726 of each of the heat dissipating fins 72 into a mold (not shown). Step S204 is then performed to pour a melted metal material (e.g. aluminum, etc.) into the mold. Finally, step S206 is performed to process the melted metal material by a die casting process so as to form the base 70, wherein the substrate 700 of the base 70 covers the fixing portion 722 and the protruding structure 726 of each of the heat dissipating fins 72, as shown in FIG. 11. In this embodiment, the overflow-proof structure 724 of each of the heat dissipating fins 72 is capable of preventing the melted metal material from overflowing during the die casting process so as to prevent deckle edge from being generated. When the length L of the overflow-proof structure 724 protruded from the fixing portion 722 is between 1 mm and 10 mm, the overflow-proof structure 724 can prevent the melted metal material from overflowing during the die casting process effectively so as to prevent deckle edge from being generated. Furthermore, the protruding structure 726 of each of the heat dissipating fins 72 can cooperate with the overflow-proof structure 724 to hold the metal material so as to enhance the combination strength between the base 70 and the heat dissipating fins 72.

Referring to FIG. 12 again, the heat pipes 34 shown in FIG. 7 can be also disposed in the substrate 700 of the base 70 so as to enhance heat dissipating efficiency. It should be noted that if the base 70 is formed by an aluminum die casting process, each of the heat pipes 34 may be disposed in an aluminum sleeve 36 (as shown in FIG. 7) and then the heat pipe 34 and the aluminum sleeve 36 are put into a mold with the heat dissipating fins 72 for the die casting process.

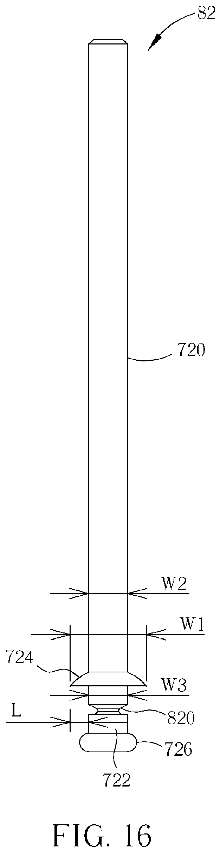

Referring to FIG. 16 along with FIG. 13, FIG. 16 is a cross-sectional view illustrating a heat dissipating fin 82 according to an embodiment of the invention. The difference between the heat dissipating fin 82 and the aforesaid heat dissipating fin 72 is that the heat dissipating fin 82 further includes a recess structure 820. As shown in FIG. 16, the recess structure 820 is formed on the fixing portion 722. When the heat dissipating fin 72 shown in FIG. 13 is replaced by the heat dissipating fin 82 shown in FIG. 16, the recess structure 820 of the heat dissipating fin 82 can hold the metal material effectively so as to enhance the combination strength between the base 70 and the heat dissipating fin 82. It should be noted that the same elements in FIG. 16 and FIG. 13 are represented by the same numerals, so the repeated explanation will not be depicted herein again. Moreover, the heat dissipating fin 82 can be also formed by the forming process of the aforesaid step S200.

As mentioned in the above, when the heat dissipating device of the invention is installed outside, electronic device(s) can be accommodated in the accommodating space within the box of the base so as to protect the electronic device(s) from being battered and damaged by wind and rain. Furthermore, the invention may form the heat dissipating fin by a forming process (e.g. aluminum extrusion process, rivet forming process, etc.) first and then form the base, which covers the fixing portion of the heat dissipating fin, by a die casting process with melted metal material. The heat dissipating fin of the invention has the overflow-proof structure capable of preventing the melted metal material from overflowing during the die casting process so as to prevent deckle edge from being generated. Since the heat dissipating fin of the invention is formed by the forming process, the draft angle of the conventional heat dissipating fin is unnecessary for the heat dissipating fin of the invention. Therefore, the whole weight of the heat dissipating fin of the invention can be lighter and the height of the heat dissipating fin of the invention can be higher than the prior art. Furthermore, the number of heat dissipating fins of the invention can be increased in the heat dissipating device so that the heat dissipating area can be increased and the heat dissipating efficiency can be enhanced. Moreover, the invention may form the recess structure, the protruding structure, the hook structure and/or the extending structure on the heat dissipating fin so as to enhance the combination strength between the base and the heat dissipating fin.

## Claims

1. A method of producing a heat dissipating device (3, 3', 3", 7), the method comprising:
forming a plurality of heat dissipating fins (32, 42, 52, 62, 72, 82) by a forming process, wherein each of the heat dissipating fins (32, 42, 52, 62, 72, 82) comprises a heat dissipating portion (320, 720), and a fixing portion (322, 722);
putting the fixing portion (322, 722) of each of the heat dissipating fins (32, 42, 52, 62, 72, 82) into a mold;
pouring a melt metal material into the mold; and
processing the melt metal material by a die casting process so as to form a base (30, 70), wherein the base (30, 70) comprises a substrate (300, 700) and a box (302, 702), the substrate (300, 700) and the box (302, 702) are formed integrally, the box (302, 702) has an accommodating space (306, 706) therein, and the substrate (300, 700) covers the fixing portion (322, 722) of each of the heat dissipating fins (32, 42, 52, 62, 72, 82);
**characterized in that** each of the heat dissipating fins (32, 42, 52, 62, 72, 82) comprises an overflow-proof structure (324, 724) connected between the heat dissipating portion (320, 720) and the fixing portion (322, 722), wherein a width of the overflow-proof structure (324, 724) is larger than a width of the heat dissipating portion (320, 720) and larger than a width of the fixing portion (322, 722), such that the overflow-proof structure (324, 724) of each of the heat dissipating fins (32, 42, 52, 62, 72, 82) is capable of preventing the melt metal material from overflowing during the die casting process.

2. The method of claim 1 further **characterized in that** the base (30, 70) comprises a flange (304, 704) protruding from a periphery of the box (302, 702).

3. The method of claim 1 further **characterized in that** the method further comprising:
disposing a plurality of heat pipes (34) in the substrate (300).

4. The method of claim 1 further **characterized in that** a length of the overflow-proof structure (324, 724) protruded from the fixing portion (322, 722) is between 1 mm and 10 mm.

5. The method of claim 1 further **characterized in that** each of the heat dissipating fins (32, 42, 52, 82) comprises a recess structure (326, 820) formed on the fixing portion (322, 722).

6. The method of claim 5 further **characterized in that** each of the heat dissipating fins (52) comprises a hook structure (520) formed in the recess structure (326).

7. The method of claim 1 further **characterized in that** each of the heat dissipating fins (42, 72, 82) comprises a protruding structure (420, 726) protruded from one end of the fixing portion (322, 722).

8. The method of claim 1 further **characterized in that** each of the heat dissipating fins (62) comprises an extending structure (620) extended from the overflow-proof structure (324) toward the fixing portion (322).

9. The method of claim 8 further **characterized in that** the overflow-proof structure (324) and the extending structure (620) are formed as a U-shape.

10. The method of claim 1 further **characterized in that** a thickness of the overflow-proof structure (324) is uniform.

11. The method of claim 1 further **characterized in that** a thickness of the overflow-proof structure (724) varies gradiently.

12. The method of claim 1 further **characterized in that** each of the heat dissipating fins (32, 42, 52, 62) is a flat-type heat dissipating fin.

13. The method of claim 1 further **characterized in that** each of the heat dissipating fins (72, 82) is a cylinder-type heat dissipating fin.

## Patentansprüche

1. Verfahren zur Herstellung einer Wärmeableitungsvorrichtung (3, 3', 3", 7), wobei das Verfahren umfasst:
Bilden einer Vielzahl von Wärmeableitrippen (32, 42, 52, 62, 72, 82) durch einen bildenden Prozess, wobei jede der Wärmeableitrippen (32, 42, 52, 62, 72, 82) einen Wärmeableitabschnitt (320, 720) und einen Befestigungsabschnitt (322, 722) umfasst;
Einsetzen des Befestigungsabschnitts (322, 722) jeder der Wärmeableitrippen (32, 42, 52, 62, 72, 82) in eine Form;
Einfügen des Befestigungsabschnitts (322, 722) jeder der Wärmeableitrippen (32, 42, 52, 62, 72, 82) in eine Form;
Gießen eines Schmelzmetallmaterials in die Form; und
Verarbeiten des Schmelzmetallmaterials durch einen Druckgussprozess, um eine Basis (30, 70) zu bilden, wobei die Basis (30, 70) ein Substrat (300, 700) und einen Kasten (302, 702) umfasst, wobei das Substrat (300, 700) und der Kasten (302, 702) integral ausgebildet sind, der Kasten (302, 702) einen Aufnahmeraum (306, 706) darin aufweist und das Substrat (300, 700) den Befestigungsabschnitt (322, 722) jeder der Wärmeableitrippen (32, 42, 52, 62, 72, 82) abdeckt;
**dadurch gekennzeichnet, dass** jede der Wärmeableitrippen (32, 42, 52, 62, 72, 82) eine Überlaufsicherungsstruktur (324, 724) umfasst, die zwischen dem Wärmeableitabschnitt (320, 720) und dem Befestigungsabschnitt (322, 722) verbunden sind, und wobei eine Breite der Überlaufsicherungsstruktur (324, 724) größer als eine Breite des Wärmeableitabschnitt (320, 720) und größer als eine Breite des Befestigungsabschnitts (322, 722) ist, so dass die Überlaufsicherungsstruktur (324, 724) jeder der Wärmeableitrippen (32, 42, 52, 62, 72, 82) in der Lage ist, das Überlaufen des Schmelzmetallmaterials während des Druckgussprozesses zu verhindern.

2. Verfahren nach Anspruch 1, ferner **dadurch gekennzeichnet, dass** die Basis (30, 70) einen Flansch (304, 704) umfasst, der aus einem Rand des Kastens (302, 702) herausragt.

3. Verfahren nach Anspruch 1, ferner **dadurch gekennzeichnet, dass** das Verfahren ferner umfasst:
Anordnen einer Vielzahl von Wärmeleitrohren (34) in dem Substrat (300).

4. Verfahren nach Anspruch 1, ferner **dadurch gekennzeichnet, dass** eine Länge der Überlaufsicherungsstruktur (324, 724), die aus dem Befestigungsabschnitt (322, 722) herausragt, zwischen 1 mm und 10 mm beträgt.

5. Verfahren nach Anspruch 1, ferner **dadurch gekennzeichnet, dass** jede der Wärmeableitrippen (32, 42, 52, 82) eine Aussparungsstruktur (326, 820) umfasst, die auf dem Befestigungsabschnitt (322, 722) ausgebildet ist.

6. Verfahren nach Anspruch 5, ferner **dadurch gekennzeichnet, dass** jede der Wärmeableitrippen (52) eine Hakenstruktur (520) umfasst, die in der Aussparungsstruktur (326) ausgebildet ist.

7. Verfahren nach Anspruch 1, ferner **dadurch gekennzeichnet, dass** jede der Wärmeableitrippen (42, 72, 82) eine vorstehende Struktur (420, 726) umfasst, die von einem Ende des Befestigungsabschnitts (322, 722) vorsteht.

8. Verfahren nach Anspruch 1, ferner **dadurch gekennzeichnet, dass** jede der Wärmeableitrippen (62) eine sich erstreckende Struktur (620) umfasst, die sich von der Überlaufsicherungsstruktur (324) zu dem Befestigungsabschnitt (322) erstreckt.

9. Verfahren nach Anspruch 8, ferner **dadurch gekennzeichnet, dass** die Überlaufsicherungsstruktur (324) und die sich erstreckende Struktur (620) als U-Form ausgebildet sind.

10. Verfahren nach Anspruch 1, ferner **dadurch gekennzeichnet, dass** eine Dicke der Überlaufsicherungsstruktur (324) gleichmäßig ist.

11. Verfahren nach Anspruch 1, ferner **dadurch gekennzeichnet, dass** eine Dicke der Überlaufsicherungsstruktur (724) gradientenweise variiert.

12. Verfahren nach Anspruch 1, ferner **dadurch gekennzeichnet, dass** jede der Wärmeableitrippen (32, 42, 52, 62) eine Wärmeableitrippe vom flachen Typ ist.

13. Verfahren nach Anspruch 1, ferner **dadurch gekennzeichnet, dass** jede der Wärmeableitrippen (72, 82) eine Wärmeableitrippe vom Zylindertyp ist.

## Revendications

1. Procédé de production d'un dispositif de dissipation de chaleur (3, 3', 3", 7), ce procédé comprenant :
le formage d'une pluralité d'ailettes de dissipation de chaleur (32,42,52,62,72,82) par un procédé de formage, chacune des ailettes de dissipation de chaleur (32,42,52,62,72,82) comprenant une section de dissipation de chaleur (320,720) et une section de fixation (322,722) ;
la mise de la section de fixation (322,722) de chacune des ailettes de dissipation de chaleur (32,42,52,62,72,82) dans un moule ;
l'intégration d'un matériau métallique fondu dans le moule ; et
le traitement du matériau métallique fondu par un processus de moulage sous pression de manière à former une base (30,70), la base (30,70) comprenant un substrat (300,700) et une boîte (302,702), le substrat (300,700) et la boîte (302,702) formant un seul bloc, la boîte (302,702) comportant un espace de logement à l'intérieur, et le substrat (300,700) couvrant la section de fixation (322,722) de chacune des ailettes de dissipation de chaleur (32,42,52,62,72,82) ;
**caractérisé en ce que** chacune des ailettes de dissipation de chaleur (32,42,52,62,72,82) comprend une structure anti-débordement (324,724) connectée entre la section de dissipation de chaleur (320,720) et la section de fixation (322,722),
une largeur de la structure anti-débordement (324,724) étant supérieure à une largeur de la section de dissipation de chaleur (320,720) et supérieure à une largeur de la section de fixation (322,722), de sorte que la structure anti-débordement (324,724) de chacune des ailettes de dissipation de chaleur (32,42,52,62,72,82) est capable d'empêcher le matériau métallique fondu de déborder pendant le processus de moulage par pression.

2. Procédé selon la revendication 1, **caractérisé en outre en ce que** la base (30,70) comprend une bride (304,704) dépassant d'une périphérie de la boîte (302,702).

3. Procédé selon la revendication 1, **caractérisé en outre en ce que** ce procédé comprend en outre :
la disposition d'une pluralité de tuyaux chauffants (34) dans le substrat (300).

4. Procédé selon la revendication 1, **caractérisé en outre en ce qu'**une longueur de la structure anti-débordement (324,724) dépassant de la section de fixation (322,722) est de 1 mm à 10 mm.

5. Procédé selon la revendication 1, **caractérisé en outre en ce que** chacune des ailettes de dissipation de chaleur (32,42,52,82) comprend une structure en retrait (326,820) formée sur la section de fixation (322,722).

6. Procédé selon la revendication 5, **caractérisé en outre en ce que** chacune des ailettes de dissipation de chaleur (52) comprend une structure à crochet (520) formée dans la structure en retrait (326).

7. Procédé selon la revendication 1, **caractérisé en outre en ce que** chacune des ailettes de dissipation de chaleur (42,72,82) comprend une structure saillante (420,726) dépassant d'une extrémité de la section de fixation (322,722).

8. Procédé selon la revendication 1, **caractérisé en outre en ce que** chacune des ailettes de dissipation de chaleur (62) comprend une structure en extension (620) s'étendant depuis la structure anti-débordement (324) en direction de la section de fixation (322).

9. Procédé selon la revendication 8, **caractérisé en outre en ce que** la structure anti-débordement (324) et la structure en extension (620) sont réalisées en forme de U.

10. Procédé selon la revendication 1, **caractérisé en outre en ce que** l'épaisseur de la structure anti-débordement (324) est uniforme.

11. Procédé selon la revendication 1, **caractérisé en outre en ce que** l'épaisseur de la structure anti-débordement (724) varie graduellement.

12. Procédé selon la revendication 1, **caractérisé en outre en ce que** chacune des ailettes de dissipation de chaleur (32,42,52,62) est une ailette de dissipation de chaleur de type plat.

13. Procédé selon la revendication 1, **caractérisé en outre en ce que** chacune des ailettes de dissipation de chaleur (72,82) est une ailette de dissipation de chaleur de type cylindrique.
